# EUROPÄISCHE PATENTSCHRIFT

(11) **EP 4 246 602 B1**
(45) Veröffentlichungstag und Bekanntmachung des Hinweises auf die Patenterteilung: **07.10.2026**
(21) Anmeldenummer: 22161887.9
(22) Anmeldetag: 14.03.2022
(51) Int. Cl.: H10N 60/20, H10N 60/01, H01B 12/06, H01B 7/22

(54) **HERMETISCH DICHTER HOCHTEMPERATURSUPRALEITENDER BANDLEITER UND HERSTELLUNGSVERFAHREN**
HERMETICALLY SEALED HIGH TEMPERATURE SUPERCONDUCTOR TAPE CONDUCTOR AND PRODUCTION PROCESS
BANDE SUPRACONDUCTRICE À HAUTE TEMPÉRATURE HERMÉTIQUEMENT ÉTANCHE ET PROCÉDÉ POUR LA PRODUIRE

(43) Veröffentlichungstag der Anmeldung: 20.09.2023
(73) Patentinhaber: Theva Dünnschichttechnik GmbH, 85737 Ismaning (DE)
(72) Erfinder: DR. PRUSSEIT, Werner, 85737 Ismaning (DE)
(74) Vertreter: Bardehle Pagenberg Partnerschaft mbB Patentanwälte Rechtsanwälte

(56) Entgegenhaltungen:
- EP-A1- 3 499 519
- WO-A1-2015/049357
- WO-A1-2015/049357
- WO-A1-2018/227083
- WO-A2-2017/151233
- DE-C1- 19 803 687
- JP-A- S5 640 289
- US-A1- 2006 073 979

## Beschreibung

### 1. Technisches Gebiet

Die Erfindung betrifft einen hochtemperatursupraleitenden Bandleiter (HTS-Bandleiter), der durch eine spiralförmig in mehreren Wicklungen um den HTS-Bandleiter gewickelte Metallfolie gegen Umwelteinflüsse hermetisch abgedichtet ist.

### 2. Stand der Technik

HTS-Bandleiter werden in der Technik zum Transport hoher Ströme, z.B. in Kabeln und Stromschienen, zur Erzeugung hoher Magnetfelder in der Analytik oder der Medizintechnik, zur Strahlführung in Beschleunigern oder zum Plasmaeinschluss in Fusionsreaktoren eingesetzt. Zudem kann der schnelle, dynamische Übergang vom verlustlosen supraleitenden Zustand in den normalleitenden Zustand bei Überlastung für schnelle Schalter und für Strombegrenzer verwendet werden.

In vielen dieser Einsatzbereiche erfolgt die Kühlung der HTS-Bandleiter durch Eintauchen bzw. Immersion in ein flüssiges, kryogenes Medium wie flüssigen Stickstoff (Siedepunkt bei 77 K), flüssigen Wasserstoff (Siedepunkt bei 21 K), Neon (Siedepunkt bei 27 K) oder flüssiges Helium (Siedepunkt bei 4,2 K).

Moderne HTS-Bandleiter (sog. 2. Generation oder 2G) umfassen ein flexibles Metallsubstrat, das durch chemische oder physikalische Verfahren mit dem verwendeten HTS-Material beschichtet wird. Dieses entstammt gewöhnlich der sog. 123-Materialklasse mit der Zusammensetzung RBa₂Cu₃O₇, wobei R ein Element oder eine Mischung aus Elementen der Gruppe der seltenen Erden (z.B. Gd, Eu, Dy, Hf) oder Yttrium (Y) bezeichnet. Da die HTS-Beschichtung typischerweise bei hohen Temperaturen (z.B. bei T > 650°C) erfolgt, kann die HTS-Beschichtung nicht direkt auf die Metallfolie aufgebracht werden. In Abhängigkeit vom verwendeten Herstellungsverfahren kommen unterschiedliche Zwischenschichten, sog. Pufferschichten, zum Einsatz, die zum einen als Diffusionsbarriere wirken, zum anderen eine kristallographische Orientierung vermitteln oder Parameter des Kristallgitters für die Epitaxie der HTS-Schicht anpassen. Sowohl die Abscheidung der Pufferschichten als auch der HTS-Schicht(en) kann mit unterschiedlichen Verfahren erfolgen, z.B. chemisch durch sog. *metal-organic-deposition* (MOD) eines amorphen Vorläufermaterials (*precursors*), der durch Temperaturbehandlung kalziniert und in die gewünschte Phase kristallisiert wird, durch *metal-organic chemical vapor deposition* (MOCVD), oder unterschiedliche physikalische Vakuumbeschichtungsverfahren (PVD).

Bei Umwandlung und beim Wachstum der HTS-Schichten und/oder der Pufferschichten können Hohlräume im Schichtpaket auftreten. Besonders ausgeprägt ist die Entstehung von Hohlräumen, wenn säulenartiges Wachstum der Schichten auftritt, wie z.B. bei der sog. *inclined substrate deposition* (ISD). Bei diesem Verfahren wird eine orientierte Pufferschicht (zumeist aus MgO) erzeugt, indem das Material mit hoher Abscheiderate und unter einem Winkel schräg zur Substratoberfläche aufgedampft wird (vgl. z.B. EP 0 909 340). Dadurch bildet sich ein sog. Wald von Säulen, die sich mit zunehmender Schichtdicke verbreitern und zusammenwachsen. Obwohl die MgO-Schicht an ihrer Oberfläche geschlossen erscheint, ist sie daher von vertikalen Zwischenräumen durchzogen. Aber auch bei anderen Verfahren wie dem MOD entstehen in den Schichten durch Festkörperreaktionen oft Hohlräume. Hinzu kommt, dass die HTS-Bandleiter im Laufe des Fertigungsprozesses ausgehend von größerer Bandbreite oft zu schmäleren Bändern geschnitten werden. In diesem Fall wird das Schichtpaket an der Schnittkante offengelegt. Zudem können Risse entstehen, die von der Seite in die Schichten hineinlaufen.

In weiteren Fertigungsschritten werden die HTS-Bandleiter zumeist noch mit dünnen Metallschichten aus Silber (Ag) oder Kupfer (Cu) ummantelt. So können z.B. galvanischen Verfahren verwendet werden um Cu-Schichten mit einer typischen Dicke von 5 - 20 µm abzuscheiden (vgl. JP 07335051 oder EP 1 639 609). Diese umlaufenden Metallschichten dienen dem Schutz, der elektrischen Stabilisierung und der Stromeinspeisung in die darunterliegende HTS-Schicht. Jedoch sind auch solche Ag oder Cu-Schichten selten zu 100% frei von Beschädigungen, Löchern oder Kanälen. Insbesondere am Rand, d.h. an einer Schnittkante, ist die Haftung solcher Schichten oft reduziert und die Schichten können leicht zerkratzt und damit geöffnet werden (z.B. durch Schaben an Führungsrollen bei Herstellung).

Taucht man solche HTS-Bandleiter über mehrere Stunden in ein kryogenes Flüssigkeitsbad, so sickert die Kühlflüssigkeit langsam in die vorhandenen Hohlräume ein. Dies wird dadurch verstärkt, dass in den Hohlräumen befindliche Luft unterhalb von 77 K kondensiert und dadurch ein Unterdruck entsteht, der das Einsickern der Kühlflüssigkeit durch Kapillarkräfte verstärkt. Unter normalen Umständen führt diese Infiltration von Kühlflüssigkeit in die Schichten des HTS-Bandleiters nicht zu einer Beeinträchtigung der Funktion des Supraleiters.

Wärmt man den HTS-Bandleiter jedoch schnell auf, z.B. indem man ihn schnell aus der Kühlflüssigkeit hebt, oder falls durch einen sog. *Quench* starke lokale Erwärmung auftritt, so kann die sich in den Hohlräumen befindende Kühlflüssigkeit schlagartig verdampfen, was mit einer 700 - 1000-fachen Volumenänderung einhergeht. Die engen Kanäle in den Schichten des HTS-Bandleiters, durch die die Kühlflüssigkeit langsam eingesickert ist und die davon abgesehen großteils geschlossenen Oberflächen des HTS-Bandleiters erlauben jedoch keinen schnellen Gasaustritt, so dass es lokal zu sehr hohem Druckanstieg kommt, der das umgebende Material sprengt und / oder zu einer Blase aufwölbt. Dieser Effekt ist auch als sog. *ballooning* bekannt. Bei einem solchen Ereignis wird der HTS-Bandleiter an dieser Stelle irreversibel, mechanisch zerstört.

Besonders flüssiger Wasserstoff und Helium weisen eine sehr geringe Viskosität und hohe Diffusivität auf, so dass selbst kleinste Öffnungen und Zugänge ausreichen, um die darunterliegenden Hohlräume zu infiltrieren.

Das vorstehend beschriebene Verhalten tritt auch bei HTS-Leitern der 1. Generation (1G) auf, die durch ein metallurgisches *powder-in-tube* (PIT) Verfahren hergestellt werden. Dazu wird ein Pulver eines HTS-Materials in ein Metallrohr eingefüllt, gepresst, gesintert und gewalzt, so dass HTS-Keramikfilamente in einer Metallmatrix entstehen. Auch bei diesem Verfahren entstehen in der HTS-Füllung Hohlräume und durch Haarrisse in der metallischen Matrix kann Kühlflüssigkeit einsickern. Die Firma AMSC entwickelte dafür eine Konfiguration, bei der der HTS-Bandleiter beidseitig mit einer Metallfolie laminiert und verlötet wird. Durch einen Überstand der Folien auf beiden Seiten entstehen zwei Kanäle längs des Leiters, die mit einem Lotmaterial gefüllt werden und damit seitliche eine Lotbrücke bilden. Diese Anordnung ist in EP 1 203 415 beschrieben. Da sich die Geometrien von 1G und 2G Bandleitern ähnlich sind, eignet sich dieses Verfahren ebenso für 2G HTS-Bandleiter. Ein ähnliches Verfahren zum beidseitigen Einlaminieren eines HTS-Bandleiters mit thermoplastischen Kunststofffolien ist in WO 2013/004392 A1 beschrieben.

Ein weiteres Verfahren zum Einpacken eines HTS-Bandleiters wurde von Fujikura entwickelt und ist in EP 2 940 699 und EP 2 770 513 beschrieben. Dabei wird eine mit Lot beschichtete Metallfolie mit doppelter Breite des HTS-Bandleiters um diesen herum gefaltet und verlötet, so dass Vorderseite und Kanten komplett bedeckt sind. Die Naht auf der Rückseite des Leiters kann dabei auch mit Lot gefüllt werden, so dass auch von dort kein Einsickern von Kühlflüssigkeit mehr möglich ist.

Um HTS-Bandleiter ohne Löcher elektrisch zu isolieren, wurde u.a. ein Verfahren entwickelt, bei dem dieser mit einem dünnen Kunststoffband, umwickelt wird. Dieses kann z.B. aus Polyimid (Handelsname: *Kapton*) wie in der DE 3 823 938 beschrieben oder aus Polyester bestehen (vgl. DE 10 2004 048 439). Polyimid hat einen geringen Wärmeausdehnungskoeffizienten und versprödet kaum und ist deshalb für den Einsatz bei tiefkalten Temperaturen besonders geeignet.

Die vorstehend beschriebenen Verfahren zur Umhüllung von HTS-Bandleitern werden in der Praxis angewandt. Allerdings ergeben sich dabei auch Schwierigkeiten. Die im Stand der Technik verwendetem Metallbänder sind oft nicht ideal gerade, sondern weisen typischerweise einen gewissen Säbel, d.h., eine Abweichung von der geraden Konfiguration auf. Dadurch ist das akkurate Justieren und Führen von drei parallelen Bändern beim Einlaminieren problematisch, was die Fertigung langer Stücklängen schwierig macht. Tatsächlich lässt sich die genaue Lage es innenliegenden HTS-Bandleiters, des sog. *insert* relativ zum Rand der Metallbänder kaum kontrollieren. Durch seitlichen Versatz kann sich der HTS-Bandleiter ganz auf eine Seite verschieben, so dass dort kein Überstand der beiden Metallfolien und keine Lotbrücke entsteht. Das sog. *sandwich* platzt an solchen Stellen häufig auf und Kühlflüssigkeit kann dort in den HTS-Bandleiter eindringen.

In manchen Anwendungen wie z.B. einem supraleitenden Strombegrenzer kann der HTS-Bandleiter durch kurzzeitige Überlastung (Quenchen) zudem derart erhitzen (> 250°C), dass die Schmelztemperatur des Lotmaterials erreicht wird und sich der Sandwichverbund auflöst. In diesem Fall stellt die Laminierung auch keinen mechanischen Schutz mehr dar.

Beim Umfalten eines HTS Bandleiters durch eine umgeschlagene Metallfolie, stellt diese zumindest eine mechanisch stabile Klammer dar, die sich selbst bei Erweichung des Lots nicht löst. Das Verfahren ist mechanisch jedoch sehr anspruchsvoll und kann an Verbindungsstellen des HTS-Bandleiters Probleme bereiten. Solche Verbindungsstellen sind durch überlappende HTS-Bandleiter deutlich dicker - oft sogar doppelt so dick wie der Einfachleiter. Beim Einfalten entstehen hier typischerweise Kanäle und Hohlräume, die bei einer typischen Lotauflage von ca. 10 µm nicht gefüllt werden.

Auch das Umhüllen mit Kunststoff ist allein schon aufgrund der Materialauswahl nicht geeignet, einen HTS-Bandleiter gegen das Einsickern von Kühlflüssigkeiten abzudichten. Zudem verspröden Kleber auf der Rückseite bei tiefen Temperaturen und Kunststoff bildet Mikrorisse und besitzt selbst im unversehrten Zustand eine gewisse Durchlässigkeit für Gase und leichte Elemente.

Das der vorliegenden Erfindung zu Grunde liegende Problem besteht somit darin, einige der vorstehend beschriebenen Nachteile des Stands der Technik zumindest teilweise zu verringern.

In diesem Zusammenhang beschreibt EP 3 499 519 A1 einen supraleitenden Oxiddraht mit einem supraleitenden Laminat, das ein bandförmiges Substrat, eine auf einer Seite des Substrats vorgesehene Zwischenschicht, eine auf der Zwischenschicht vorgesehene supraleitende Oxidschicht und eine Oberfläche der supraleitenden Oxidschicht bedeckende Schutzschicht umfasst, wobei zwei der supraleitenden Laminate so angeordnet sind, dass sie in einer Dickenrichtung übereinander liegen, und die beiden supraleitenden Laminate durch eine Metallschicht integriert sind, die zumindest auf beiden Seitenflächen der beiden supraleitenden Laminate in einer Breitenrichtung vorgesehen ist, so dass die beiden supraleitenden Laminate einen nicht fixierten Abschnitt dazwischen bilden, der in einer Längsrichtung des supraleitenden Laminats nicht fixiert ist.

Die Patentanmeldung US 2006 / 073979 A1 beschreibt das spiralförmige Umwickeln eines Bandsupraleiters mit einer Metallfolie und das anschließende Aufbringen einer äußeren Lotschicht.

### 3. Zusammenfassung der Erfindung

Das vorstehend angeführte technische Problem wird zumindest teilweise durch den Gegenstand der unabhängigen Ansprüche der vorliegenden Erfindung gelöst. Beispielhafte Ausführungsformen sind Gegenstand der abhängigen Ansprüche.

In einer Ausführungsform stellt die vorliegende Erfindung einen Supraleiter bereit, der einen HTS-Bandleiter aufweist und zumindest eine Lage Metallfolie, die spiralförmig in mehreren Wicklungen um den HTS-Bandleiter gewickelt und mit diesem verlötet ist und dadurch eine Armierung ausbildet, die den HTS-Bandleiter hermetisch abschließt.

Der Begriff *Supraleiter* ist im Kontext der vorliegenden Anmeldung technisch zu verstehen, und zwar im Sinne von einem Stück elektrischem Leiter, der supraleitende Eigenschaften aufweist. Ferner sind sich die Erfinder dessen bewusst, dass statt einer Verlötung, die wegen der wesentlich besseren elektrischen, thermischen und mechanischen Eigenschaften - insbesondere bei kryogenen Temperaturen - klar zu bevorzugen ist, auch andere Verbindungstechniken wie etwa Verkleben mit einem ggf. gut wärmeleitfähigen Epoxidkleber verwendet werden könnten, um den Verbund zwischen HTS-Bandleiter und Metallfolie herzustellen. Daher sind solche alternativen Supraleiter ebenfalls Teil der vorliegenden Erfindung.

Insbesondere kann die Metallfolie reines oder niedrig legiertes Cu oder Al aufweisen und/oder eine Dicke zwischen 10 µm und 100 µm, bevorzugt zwischen 20 µm und 50 µm aufweisen. Alternativ oder zusätzlich kann eine Lotschicht auf zumindest einer Oberfläche der Metallfolie aufgetragen sein, die einen Schmelzpunkt unterhalb 280°C, bevorzugt unterhalb 250°C aufweist und eine Dicke zwischen 2 µm und 30 µm, bevorzugt zwischen 5 µm und 15 µm aufweist.

Eine solche hermetische Armierung bildet dadurch eine elektrisch leitfähige, gut an die HTS-Schicht angekoppelte, mechanisch stabile und vor allem gegen das langsame Einsickern von typischen Kühlflüssigkeiten (LH₂, LHe, LN₂, etc.) hermetisch dichte Umhüllung des HTS-Bandleiters, welche die vorstehend diskutierten Nachteile des Stands der Technik zumindest teilweise beseitigt.

Ein solcher Supraleiter lässt sich beispielsweise mit dem im unabhängigen Verfahrensanspruch spezifizierten Verfahren herstellen.

Ein solches Verfahren und das vorstehend spezifizierte Konstruktionsprinzip adressieren insbesondere die vorstehend beschriebenen Probleme durch das Umwickeln des HTS-Bandleiters mit einer metallischen Folie, die sich zuverlässig auch über Stoßstellen und Unebenheiten aufbringen lässt und beim Wickeln selbst justiert. Dazu wird der HTS-Bandleiter beispielsweise mit einer duktilen Metallfolie umwickelt. Diese kann mit einer dünnen Schicht aus Lotmaterial überzogen sein, die nach dem Umwickeln unter Einwirkung von Wärme und Druck fest mit den HTS-Bandleiteroberflächen verlötet wird.

Die Metallfolie (bzw. das Metallband), mit welcher der HTS-Bandleiter spiralförmig umwickelt wird, sollte vorzugsweise zum einen eine leichte plastische Verformbarkeit, aber anderseits auch eine ausreichende Zugfestigkeit aufweisen, um beim Wickeln über die Bandkanten mit moderaten Zugspannungen von z.B. 10 - 150 MPa nicht abzureißen. Gut geeignet erscheinen Metalle wie Kupfer, Aluminium, Silber, Nickel, Zinn, Blei, Indium und andere, die im reinen Zustand oder mit einem niedrigen Gehalt an zulegierten Bestandteilen sehr duktil sind oder nach dem Auswalzen zu einer dünnen Folie durch Wärmebehandlung weich geglüht werden können. Für die technische Anwendung besonders bevorzugt sind Kupfer, Aluminium und Silber ggf. mit einem niedrigen Anteil an Legierungszusätzen oder auch eine weiche Bronze. Die Materialauswahl wird dabei auch bestimmt von den anwendungsspezifischen Anforderungen an die elektrische Leitfähigkeit, die Wärmeleitung und die Wärmekapazität.

Die vorstehend beschriebene spiralförmige Umwicklung des HTS-Bandleiters mit einer Metallfolie vermeidet die Nachteile existierender Verfahren und weist darüber hinaus u.a. eine Reihe von Vorteilen für die Fertigung auf. So bildet die Metallfolie eine mechanisch feste Armierung um den innenliegenden, umwickelten HTS-Bandleiter.

So könnten im Inneren als *insert* auch zwei oder mehrere HTS-Bandleiter und/oder ein oder mehrere zusätzliche Metallbänder liegen und so einen Verbundleiter bilden. Auch Verbindungstellen, Patches und Bereiche variabler Dicke werden durch das Umwickeln sicher ummantelt. Das Verfahren ist auch tolerant, was einen möglichen Säbel des *inserts* angeht und passt sich innerhalb der Toleranzen durch leichten Versatz einer gewissen Biegung an. Beispielsweise liegt der tolerierbare Säbel unterhalb von 5 mm/m (Abweichung von der Geraden). Zudem kann die beanspruchte Wickeltechnik sequenziell mehrfach angewandt werden, um eine absolut sichere Versiegelung oder eine gewünschte Dicke des Endprodukts zu erreichen. Dazu empfiehlt es sich, die zweite Lage gleichsinnig und mit Versatz auf Lücke aufzuwickeln, so dass die Stoßstellen der ersten Lage sicher abgedeckt sind.

Insbesondere kann das Erwärmen und / oder das Abkühlen unter Einwirken eines Anpressdrucks erfolgen, das Erwärmen erfolgt vorzugsweise, indem der umwickelte HTS-Bandleiter durch heiße Walzen oder durch eine heiße Raupe geführt wird.

Beispielsweise kann nach dem Umwickeln der HTS-Bandleiter durch heiße Rollen oder eine beheizte Raupe geführt werden, die das Lot aufschmelzen und den Verbund aufeinanderdrücken, wenn dieser abkühlt. Dadurch wird eine feste Verlötung der Materialien erreicht. Zudem läuft überschüssiges Lot durch Kapillarkräfte auch in die Stoßstellen zwischen den Schlaufen der Umwicklung und füllt diese aus.

In einigen Ausführungsformen kann beim Umwickeln eine Umlauffrequenz und ein Vortrieb des Umwickelns derart eingerichtet sein, dass die Wicklungen der zumindest einen Lage Metallfolie ohne Überlappung und auf Stoß dicht aneinander liegen. Das führt zu einer verbesserten Abschirmung gegen Umwelteinflüsse, einer möglichst homogenen Oberfläche und/oder einer möglichst geringen zusätzlichen Dicke des Supraleiters.

Alternativ oder zusätzlich kann beim Umwickeln eine Umlauffrequenz und ein Vortrieb des Umwickelns derart eingestellt sind, dass ein Steigungswinkel der Wicklungen kleiner als 45° ist und bevorzugt zwischen 20° und 30° liegt.

Dadurch lassen sich beispielsweise Supraleiter fertigen, bei denen die Metallfolie den HTS-Bandleiter unter einem Winkel kleiner als 45°, bevorzugt unter einem Winkel zwischen 20° und 30°, in Bezug zur Breite des HTS-Bandleiter umwickelt und/oder Bei denen die Wicklungen der zumindest eine Lage Metallfolie ohne Überlappung und auf Stoß dicht aneinander liegen.

Bezeichnet beispielsweise W die Breite des HTS-Bandleiters und B die Breite der aufzuwickelnden Metallfolie, so können Umlauffrequenz und Bandvortrieb so eingestellt werden, dass bei jedem Umlauf ein Versatz um eine Metallfolienbreite B erfolgt und so eine spiralförmige Umhüllung des HTS-Bandleiters auf Stoß entsteht. Der Steigungswinkel φ ergibt sich damit aus der Beziehung sin φ = B/2W. Dieser sollte nicht zu steil werden und liegt bevorzugt unterhalb von φ < 45°, besonders bevorzugt im Bereich zwischen 20° - 30°, so dass W und B ähnliche Werte annehmen.

Das hat u.a. den Vorteil, dass die eine hermetische Abdichtung einfach und schnell gefertigt werden kann und dabei der resultierende Supraleiter eine möglichst geringe Dicke und trotzdem hermetisch dichte Abdichtung aufweist.

Es hat sich gezeigt, dass es in einigen Anwendungen vorteilhaft sein kann, dass beim Umwickeln die zumindest eine Lage Metallfolie unter einer Zugspannung zwischen 10 MPa bis 100 MPa gehalten wird. Dadurch kann erreicht werden, dass die Metallfolie eng am HTS-Bandleiter anliegt und gut verlötet werden kann, beim Umwickeln der Bandkanten jedoch dort nicht abreißt.

Wie vorstehend bereits angesprochen kann, in einigen Ausführungsformen, das hier beschriebene Verfahren folgende zusätzliche Schritte umfassen: sequenzielles Umwickeln des HTS-Bandleiters mit mehreren, zueinander versetzen Lagen Metallfolie, wobei der Versatz vorzugsweise mindesten 20% und mehr bevorzugt im Wesentlichen eine halbe Bandbreite der Metallfolie beträgt. Insbesondere kann dabei jede Lage einzeln verlötet werden.

Auf diese Weise kann die Qualität der Armierung und / oder der hermetischen Abdichtung signifikant verbessert werden.

In weiteren Ausführungsformen können mehrere HTS-Bandleiter übereinander oder der Länge nach verbunden werden und der resultierende verbundenen HTS-Bandleiter anschließend umwickelt werden. Auf diese Weise können die vorstehend beschriebenen Vorteile der vorliegenden Erfindung auch auf Supraleiter mit einer wesentlich höheren Stromtragfähigkeit angewendet werden, ohne die Fertigungsverfahren und / oder die dazu notwendigen Maschinen stark abändern zu müssen.

Insbesondere können in einigen Ausführungsformen mehrere HTS-Bandleiter untereinander einen mehrlagigen Verbund bilden oder an ihren Enden überlappend verbunden sein und gemeinsam mit der Metallfolie umwickelt und verlötet sein.

In einigen Ausführungsformen kann die Haftfestigkeit der Metallfolie auf dem HTS-Bandleiter größer als 10 MPa sein, wenn die Metallfolie in einer Richtung, die normal zu einer Oberfläche des HTS-Bandleiters liegt, abgezogen wird.

Die Haftfestigkeit kann vorzugsweise über eine Haftabzugsmessung nach DIN EN ISO 4624:2016 bestimmt werden. Dieses Messverfahren kann bei HTS-Bandleitern auch zweckmäßig dahingehen modifiziert werden, dass die Bandbreite eine Abweichung vom angegebenen Stempeldurchmesser (7mm) nötig macht. Beispielsweise kann bei 4mm Bandbreite auch ein schmalerer Stempel verwenden werden. Bei 12 mm Bandbreite kann hingegen der in der Norm vorgegebene Stempel verwendet werden.

Wie vorstehend angesprochen, kann die sichere Haftung der Umwicklung bevorzugt mit einer Haftabzugsmessung sichergestellt werden. Dazu wird ein umwickeltes Bandleiterstück mit der Rückseite planparallel auf eine plane Unterlage aufgeklebt. Auf die Metallumwicklung auf der Vorderseite wird ebenfalls planparallel die Stirnfläche eines zylinderförmigen Stempels aufgeklebt. Die andere Seite des Stempels wird so in eine Zugprüfmaschine eingespannt, dass die Zugkraft axial zum Zylinder auf die Bandleiteroberfläche wirkt und keine Verkantung des Stempels auftritt. Mit dieser Methode gemessen, liegt die Haftfestigkeit der Metallfolie auf dem *insert* vorzugsweise oberhalb von 10 MPa (10 N/mm²). Wegen der Umwicklung des HTS-Bandleiters wird die Haftung nicht nur von der Verlötung bestimmt, sondern ein Teil der Kraft wird auch in die Metallfolie abgeführt, so dass deren mechanische Zugfestigkeit ebenfalls zur Haftfestigkeit beiträgt. Die Umwicklung stellt damit eine mechanisch sehr robuste Anordnung dar.

Ferner können, auch um die Qualität der Abdichtung und Armierung zu verbessern, der ein oder die mehreren verbundenen HTS-Bandleiter mit mindestens einer weiteren Lage Metallfolie umwickelt sein, so dass die Verbindungsstellen der Wicklungen der ersten Lage von der weiteren Lage abgedeckt sind und / oder der eine oder die mehreren verbundenen HTS-Bandleiter können eine umhüllende Cu-oder Ag-Schicht umfassen, die eine Dicke größer als 2 µm und bevorzugt zwischen 2 µm und 5 µm aufweist.

Die hier beschriebene Erfindung führt also zu hermetisch abgedichteten Supraleitern mit stark verbesserten mechanischen, elektrischen und thermischen Eigenschaften, die sich in unterschiedlichen Abmessungen und Formen einfach und verlässlich fertigen lassen. Die vorliegende Erfindung leistet also einen wichtigen Beitrag dazu, HTS-Bandleitertechnologie praxistauglich zu machen.

### 4. Beschreibung der Figuren

Gewisse Aspekte der vorliegenden Erfindung werden im Folgenden mit Bezugnahme auf die angefügten Figuren beschrieben. Diese Figuren zeigen:
- **Fig. 1a:**: einen schematischen HTS-Bandleiteraufbau im Querschnitt vor dem Umwickeln;
- **Fig. 1b:**: einen schematischen HTS-Bandleiteraufbau im Querschnitt nach dem Umwickeln gemäß einer Ausführungsform der vorliegenden Erfindung;
- **Fig. 2:**: eine Darstellung eines mit Metallfolie umwickelten HTS-Bandleiters gemäß einer Ausführungsform der vorliegenden Erfindung;
- **Fig. 3:**: eine Darstellung eines HTS-Bandleiters mit doppelter Umwicklung mit Versatz gemäß einer Ausführungsform der vorliegenden Erfindung;
- **Fig. 4:**: eine Darstellung eines mit Metallfolie umwickelten doppellagigen HTS-Bandleiters gemäß einer Ausführungsform der vorliegenden Erfindung; und
- **Fig. 5:**: eine Darstellung eines mit Metallfolie umwickelten, mehrlagigen Verbund-Bandleiters gemäß einer Ausführungsform der vorliegenden Erfindung.
- **Fig. 6:**: Ablaufdiagramm der Verfahrensschritte zur Herstellung eines armierten HTS-Bandleiters.

### 5. Detaillierte Beschreibung einiger Ausführungsbeispiele

Im Folgenden werden einige beispielhafte Merkmalskombinationen mit Bezugnahme auf einige beispielhafte Ausführungsformen der vorliegenden Erfindung beschrieben. Naturgemäß müssen dabei nicht alle Merkmale der beschriebenen Ausführungsformen vorhanden sein, um die vorliegende Erfindung zu realisieren. Ferner können Ausführungsformen durch Kombinieren gewisser Merkmale einer Ausführungsform mit einem oder mehreren Merkmalen einer anderen Ausführungsform modifiziert werden - falls dies technisch kompatibel und sinnvoll ist - ohne von der Offenbarung und dem Schutzumfang der vorliegenden Erfindung abzuweichen, der alleine durch die Patentansprüche definiert ist.

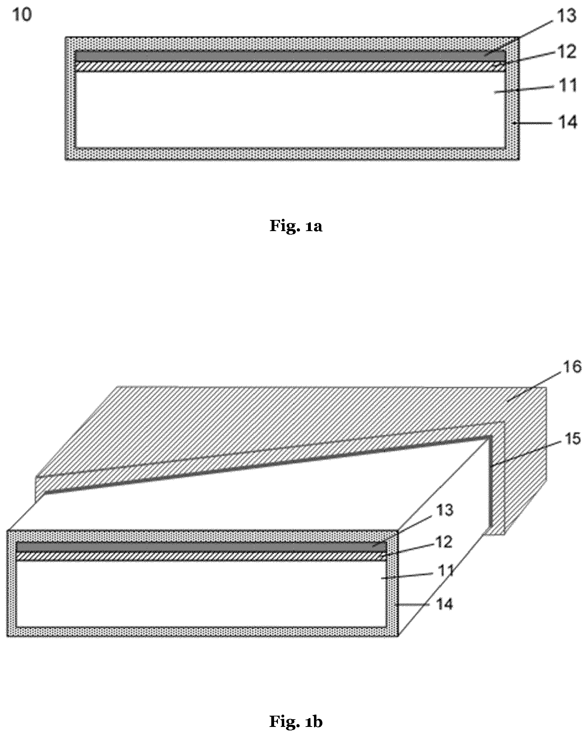

Fig. 1a zeigt den Aufbau eines HTS-Bandleiters 10 basierend auf einem dünnen Metallsubstrat 11, bevorzugt einer NiCr-Legierung wie Hastelloy C276, Legierungen aus Ni mit W oder Mo, oder einem hinreichend legierten, rostfreien Edelstahl. Die Dicke liegt bevorzugt im Bereich von 30 - 150 µm, besonders bevorzugt zwischen 50 und 100 µm. Zumindest eine Hauptfläche des Metallsubstrats ist mit einer oder mehreren Pufferschichten 12, z.B. MgO, CeO2, Y2O3, LaMnO3 und/oder LaZrO3, beschichtet auf denen die HTS-Funktionsschicht 13 abgeschieden ist. Diese umfasst im Wesentlichen eine Verbindung der Gruppe RBa₂Cu₃O₇, wobei R ein Element oder eine Mischung aus Elementen der Gruppe der seltenen Erden (z.B. Gd, Eu, Dy, Hf) oder Yttrium (Y) bezeichnet. Diesem können auch andere Metalloxide als Verunreinigungen wie beispielsweise BaMO3, wobei M für Elemente wie Zr, Hf, Ce, Sn, etc. steht, beigefügt sein, um die Magnetfeldfestigkeit der HTS-Schicht zu erhöhen. Der HTS-Bandleiter kann mit einer dünnen Schicht aus Ag umhüllt sein. Diese kann noch durch eine ebenfalls umhüllende Cu-Schicht verstärkt werden. Die beiden umhüllenden Metallschichten 14 wirken einerseits als Kontaktschichten zur Stromeinspeisung, vermitteln Haftung auf den Substratkanten und der Rückseite, und ermöglichen das Löten des HTS-Bandleiters. Die umhüllende Ag und/oder Cu-Schicht weisen eine Gesamtdicke von mindestens 2 µm, bevorzugt zwischen 2 - 5 µm auf, damit sie sich beim nachgelagerten Lötprozess nicht vollständig durch Legierung mit dem Lot auflösen. Zusätzlich kann der HTS-Bandleiter noch mit einer dünnen Lotauflage, z.B. PbSn, InAg, SAC-Lot oder anderen Weichloten mit einem Schmelzpunkt unterhalb von 280°C versehen werden, was die spätere Benetzung beim Löten verbessert.

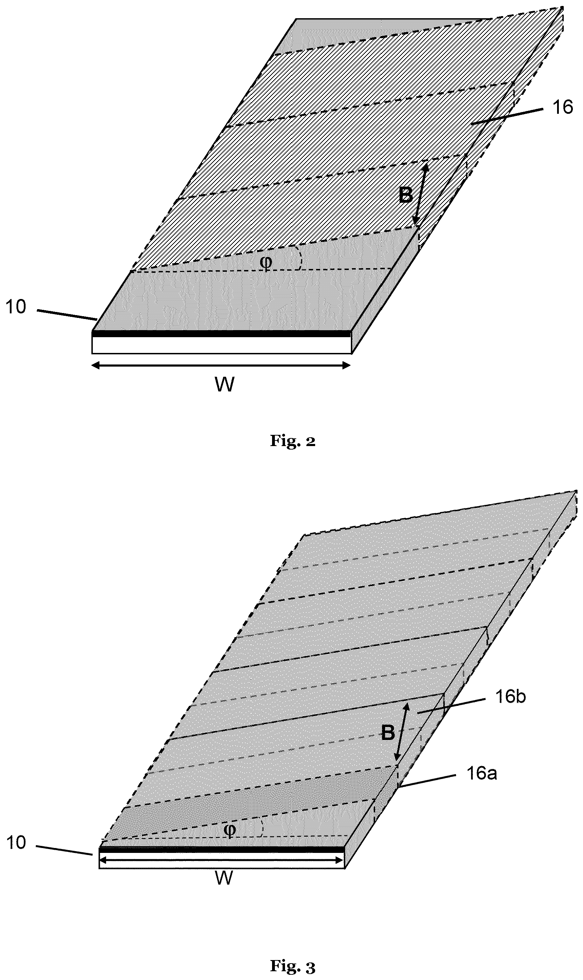

Um den HTS-Bandleiter hermetisch zu versiegeln, wird dieser wie vorstehend im Detail beschrieben und in Fig.1b und Fig. 2 gezeigt ist, fest mit einer vorzugsweise duktilen Metallfolie 16 umwickelt. Sehr gut geeignet dafür sind Metalle wie Kupfer, Aluminium, Silber, Nickel, Zinn, Blei, Indium oder Bronze. Besonders bevorzugt sind Kupfer, Aluminium und Silber, ggf. mit einem niedrigen Anteil an Legierungszusätzen und einer dünnen Auflage von Weichlot 15, mit einem Schmelzpunkt unterhalb 280°C, bevorzugt unterhalb 250°C.

Die Zugspannung mit der das Metallband bei der Herstellung des Supraleiters aufgewickelt wird, liegt je nach Material im Bereich von 10 - 150 MPa, der Steigungswinkel φ liegt bevorzugt unterhalb von 45°, besonders bevorzugt im Bereich zwischen 20° - 30°. Im Anschluss daran kann das umwickelte HTS-Band über heiße Walzen oder durch eine heiße Raupe geführt werden, wobei das Lotmaterial 15 aufgeschmolzen und der Verbund zusammengedrückt wird. Alternativ oder zusätzlich kann das Aufschmelzen auch durch ein Heißluftgebläse oder einen Infrarotstrahler erfolgen. Wie ebenfalls vorstehend diskutiert, wird hierbei vorzugsweise mit einem Anpressdruck gearbeitet.

Der Vorgang des Umwickelns und Verlötens kann auch mehrfach hintereinander wiederholt werden, um eine bestimmte Zieldicke des Verbundprodukts einzustellen. Diese Anordnung ist exemplarisch gezeigt in Fig. 3. Bevorzugt wird eine zweite Lage oder weitere Lagen Metallfolie gleichsinnig mit einem Versatz zwischen den Wicklungslagen um mindestens 20% der Bandbreite B, besonders bevorzugt ca. eine halbe Bandbreite B, auf Lücke aufgewickelt, so dass die Stoßstellen der Wicklungen der darunter liegenden Lage sicher abgedeckt sind. Eine weitere Ausführungsform betrifft einen HTS-Bandleiter (*insert*) mit Verbindungsstellen.

Sehr lange Bandleiter mit mehreren hundert Metern oder gar über tausend Meter Länge und hoher Stromtragfähigkeit werden bevorzugt durch Verbindung kürzerer Bandstücken hergestellt. Idealerweise sind diese für den Endanwender praktisch unsichtbar und verhalten sich wie der normale, einfache HTS-Bandleiter. Geeignete Verbindungsverfahren werden z.B. beschrieben in US 7071148 oder EP 2 835 838. Letztere beschreibt auch die Reparatur einer Defektstelle ähnlich wie EP 2 689 477. Bei der Verbindung werden die HTS-Bandleiter zunächst am Substrat mechanisch verbunden, z.B. verschweißt oder verlötet. Um den Stromfluss über die Stoßstelle oder über eine lokale Defektstelle zu gewährleisten, wird auf die HTS-Seite der Bandleiteroberfläche ein zweiter Bandleiter mit zugewandter HTS-Seite (*face-to-face*) als Patch aufgelötet.

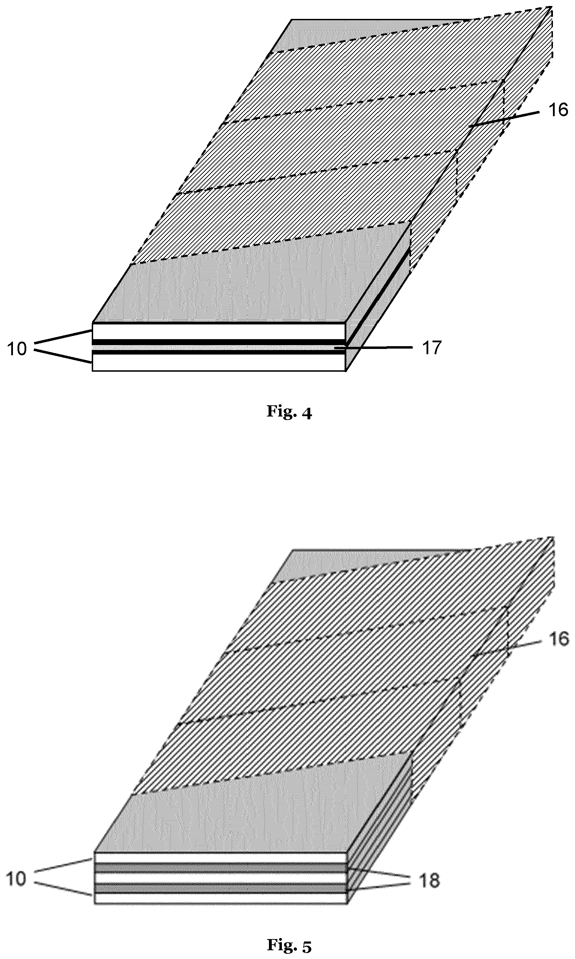

Diese Konfiguration ist in Fig. 4 dargestellt. Diese Überbrückung ist im Allgemeinen deutlich dicker als der einzelne HTS-Bandleiter. In EP 2 835 838 ist daher beschrieben, wie man vom Patch das Substrat selektiv ablösen kann, um diese Überbrückung möglichst dünn zu halten. In jedem Fall stellt die Verbindungs- oder Reparaturstelle jedoch einen empfindlichen Bereich dar, in dem sich auch die mechanischen Eigenschaften deutlich von denen des normalen HTS-Bandleiters unterscheiden.

So steigt die Steifigkeit mit der dritten Potenz der Banddicke und beim Transport über Rollen neigen solche Stellen aufgrund der abrupten Änderung der Biegesteifigkeit gerne zum Abknicken oder Aufspleißen und Delaminieren. Die vorliegende Erfindung erlaubt es solche Patches oder Verbindungstellen zu umwickeln bzw. zu bandagieren. Dies ist in Fig. 4 gezeigt und stellt eine zusätzliche mechanische Armierung dar, die den Verbund auch unter starker Verbiegung zusammenhält, den Übergang sicher hermetisch abschließt und solche Stellen nach außen praktisch unsichtbar macht.

Eine weitere Ausführungsform betrifft ein *insert* das mehrere HTS-Bandleiter 10 aufweist, die entweder mit den HTS-Schichtseiten (*face-to-face*) oder an den Rückseiten (*back-to-back*) verbunden, z.B. verlötet sind, oder eine Kombination aus HTS-Bandleitern und Metallfolien aufweist, die miteinander über die Hauptflächen verlötet 17 sind.

Im ersten Fall lässt sich dadurch die supraleitende Stromtragfähigkeit erhöhen, wobei gleichermaßen die Schwankungsbreite der Stromtragfähigkeit zurückgeht (*current sharing*)*.*

Durch einen solchen Verbund aus HTS-Bandleitern und zusätzlich eingebrachte Metallfolien oder Zwischenschichten 18, wie in Fig. 5 skizziert, lassen sich zusätzlich bestimmte Eigenschaften wie die normale elektrische Leitfähigkeit oder die Wärmekapazität gezielt anpassen. Dieser Verbund kann einfach oder auch wie in Fig. 3 gezeigt mehrfach durch die Metallfolie mechanisch armiert und hermetisch abgedichtet werden.

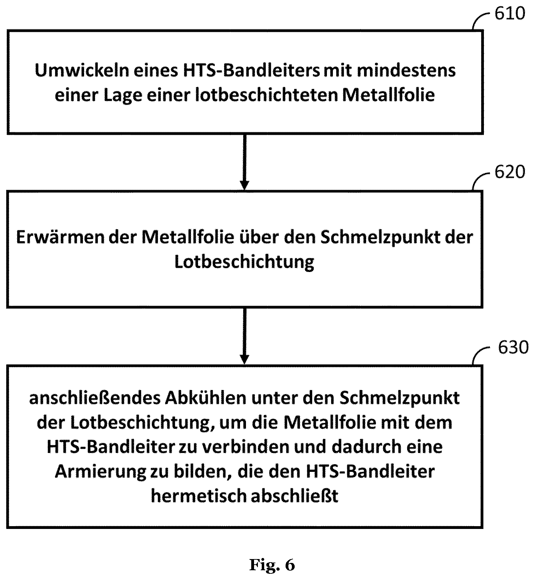

Fig. 6 zeigt ein Ablaufdiagram eines Herstellungsverfahrens gemäß einer Ausführungsform der vorliegenden Erfindung. In einem ersten Schritt 610 wird ein HTS-Bandleiter oder mehrere untereinander verbundene HTS-Bandleiter - wie vorstehend beschrieben - mit mindestens einer Lage Metallfolie spiralförmig umwickelt. Anschließend wird die Metallfolie über den Schmelzpunkt der Lotbeschichtung erwärmt 620. Schließlich wird die Metallfolie wieder unter den Schmelzpunkt der Lotbeschichtung abgekühlt 630, um die Metallfolie mit dem HTS-Bandleiter zu verbinden und dadurch eine Armierung zu bilden, die den HTS-Bandleiter hermetisch abschließt.

Weitere Ausführungsformen eines solchen Herstellungsverfahrens sind vorstehend, insbesondere in Abschnitt 3 ausführlich beschrieben.

### Bezugszeichenliste:

- 10: HTS-Bandleiter (*insert*)
- 11: Metallsubstrat
- 12: Pufferschicht(en)
- 13: HTS-Schicht
- 14: umhüllende, dünne Metallschicht
- 15: Lotschicht zwischen HTS-Bandleiter und Metallfolie
- 16, 16a: Metallfolie - 1. Wickellage
- 16b: Metallfolie - 2. Wickellage
- 17: Lotschicht zwischen HTS-Bandleitern
- 18: Zwischenschichten im Verbundleiter
- W: HTS-Bandleiterbreite
- B: Metallfolienbreite
- φ: Steigungswinkel der Wicklungen der Metallfolie

## Patentansprüche

1. Supraleiter umfassend:
einen hochtemperatursupraleitenden Bandleiter (10), HTS-Bandleiter, und
zumindest eine Lage Metallfolie (16, 16a), die spiralförmig in mehreren Wicklungen um den HTS-Bandleiter (10) gewickelt und mit diesem verlötet ist und dadurch eine Armierung ausbildet, die den HTS-Bandleiter (10) hermetisch abschließt.

2. Supraleiter nach Anspruch 1,
wobei die Metallfolie (16, 16a) reines oder niedrig legiertes Cu oder Al aufweist; und/oder
wobei die Metallfolie (16, 16a) eine Dicke zwischen 10 µm und 100 µm, bevorzugt zwischen 20 µm und 50 µm aufweist; und/oder
wobei eine Lotschicht (15) auf zumindest einer Oberfläche der Metallfolie (16, 16a) aufgetragen ist, die einen Schmelzpunkt unterhalb 280°C, bevorzugt unterhalb 250°C aufweist und eine Dicke zwischen 2 µm und 30 µm, bevorzugt zwischen 5 µm und 15 µm aufweist.

3. Supraleiter nach einem der Ansprüche 1 oder 2,
wobei die Metallfolie (16, 16a) den HTS-Bandleiter (10) unter einem Winkel kleiner als 45°. bevorzugt unter einem Winkel zwischen 20° und 30°, in Bezug zur Breite des HTS-Bandleiter (10) umwickelt; und/oder
wobei die Wicklungen der zumindest eine Lage Metallfolie (16, 16a) ohne Überlappung und auf Stoß dicht aneinander liegen.

4. Supraleiter nach einem der Ansprüche 1 - 3, wobei die Haftfestigkeit der Metallfolie (16, 16a) auf dem HTS-Bandleiter (10) größer als 10 MPa ist, wenn die Metallfolie (16, 16a) in einer Richtung, die normal zu einer Oberfläche des HTS-Bandleiters (10) liegt, abgezogen wird, vorzugsweise bestimmt über eine Haftabzugsmessung nach DIN EN ISO 4624:2016.

5. Supraleiter nach einem der Ansprüche 1 - 4, ferner umfassend:
mehrere HTS-Bandleiter (10), die untereinander einen mehrlagigen Verbund bilden oder an ihren Enden überlappend verbunden sind und gemeinsam mit der Metallfolie (16, 16a) umwickelt und verlötet sind.

6. Supraleiter nach einem der Ansprüche 1 - 5,
wobei der eine oder die mehreren verbundenen HTS-Bandleiter (10) mit mindestens einer weiteren Lage Metallfolie (16b) umwickelt sind, so dass die Verbindungsstellen der Wicklungen der ersten Lage (16, 16a) von der weiteren Lage (16b) abgedeckt sind; und / oder
wobei der eine oder die mehreren verbundenen HTS-Bandleiter (10) eine umhüllende Cu- oder Ag-Schicht umfassen, die eine Gesamtdicke größer als 2 µm und bevorzugt zwischen 2 µm und 5 µm aufweist.

7. Verfahren zum Herstellen eines Supraleiters umfassend:
spiralförmiges Umwickeln (610) eines HTS-Bandleiters (10) mit mindestens einer Lage einer Metallfolie (16, 16a), wobei die Metallfolie (16, 16a) eine Lotbeschichtung (15) aufweist;
Erwärmen (620) der Metallfolie (16, 16a) über den Schmelzpunkt der Lotbeschichtung (15); und
anschließendes Abkühlen (630) unter den Schmelzpunkt der Lotbeschichtung (15), um die Metallfolie (16, 16a) mit dem HTS-Bandleiter (10) zu verbinden und dadurch eine Armierung zu bilden, die den HTS-Bandleiter (10) hermetisch abschließt.

8. Verfahren nach Anspruch 7, wobei das Erwärmen und / oder das Abkühlen unter Einwirken eines Anpressdrucks erfolgt, das Erwärmen vorzugsweise indem der umwickelte HTS-Bandleiter (10) durch heiße Walzen oder durch eine heiße Raupe geführt wird.

9. Verfahren nach einem der Ansprüche 7 oder 8, wobei beim Umwickeln eine Umlauffrequenz und ein Vortrieb des Umwickelns derart eingerichtet sind, dass die Wicklungen der zumindest einen Lage Metallfolie (16, 16a) ohne Überlappung und auf Stoß dicht aneinander liegen.

10. Verfahren nach einem der Ansprüche 7 bis 9, wobei beim Umwickeln eine Umlauffrequenz und ein Vortrieb des Umwickelns derart eingestellt sind, dass ein Steigungswinkel (φ) der Wicklungen kleiner als 45° ist und bevorzugt zwischen 20° und 30° liegt.

11. Verfahren nach einem der Ansprüche 7 bis 10, wobei beim Umwickeln die zumindest eine Lage Metallfolie (16, 16a) unter einer Zugspannung zwischen 10 MPa bis 100 MPa gehalten wird.

12. Verfahren nach einem der Ansprüche 7 - 11, ferner umfassend:
sequenzielles Umwickeln des HTS-Bandleiters (10) mit mehreren, zueinander versetzen Lagen Metallfolie (16, 16a, 16b), wobei der Versatz vorzugsweise mindestens 20%, bevorzugt eine halbe Bandbreite (B) der Metallfolie beträgt.

13. Verfahren nach Anspruch 12, wobei jede Lage einzeln verlötet wird.

14. Verfahren nach einem der Ansprüche 7 bis 13, ferner umfassend
Verbinden mehrere HTS-Bandleiter (10) übereinander oder der Länge nach; und
anschließendes Umwickeln der verbundenen HTS-Bandleiter (10).

15. Verfahren nach einem der Ansprüche 7 - 14,
wobei die Metallfolie (16, 16a) reines oder niedrig legiertes Cu oder Al aufweist; und/oder
wobei die Metallfolie eine Dicke zwischen 10 µm und 100 µm, bevorzugt zwischen 20 µm und 50 µm; und/oder
wobei die Lotbeschichtung (15) auf zumindest einer Oberfläche der Metallfolie (16, 16a) aufgetragen ist und einen Schmelzpunkt unterhalb 280°C, bevorzugt unterhalb 250°C aufweist und eine Dicke zwischen 2 µm und 30 µm, bevorzugt zwischen 5 µm und 15 µm aufweist.

## Claims

1. A superconductor comprising:
a high temperature superconducting, HTS, tape conductor (10); and
at least one layer of metal foil (16, 16a) spirally wound around and soldered to the HTS tape conductor (10) in a plurality of windings, thereby forming a armoring hermetically sealing the HTS tape conductor (10).

2. The superconductor of claim 1,
wherein the metal foil (16, 16a) comprises pure or low alloy Cu or Al; and/or
wherein the metal foil (16, 16a) has a thickness between 10 µm and 100 µm, preferably
between 20 µm and 50 µm; and/or
wherein a solder layer (15) having a melting point below 280°C, preferably below 250°C, and a thickness between 2 µm and 30 µm, preferably between 5 µm and 15 µm, is applied to at least one surface of the metal foil (16, 16a).

3. The superconductor of one of claims 1 or 2,
wherein the metal foil (16, 16a) wraps around the HTS tape conductor (10) at an angle smaller than 45°, preferably at an angle between 20° and 30°, with respect to the width of the HTS tape conductor (10); and/or
wherein the windings of the at least one layer of metal foil (16, 16a) lie close to each other without overlap and abut.

4. The superconductor of one of claims 1-3, wherein the adhesive strength of the metal foil (16, 16a) on the HTS tape conductor (10) is greater than 10 MPa when the metal foil (16, 16a) is peeled in a direction normal to a surface of the HTS tape conductor (10), preferably determined via an adhesive peel measurement according to DIN EN ISO 4624:2016.

5. The superconductor of one of claims 1-4, further comprising:
a plurality of HTS tape conductors (10), which form a multi-layer composite with each other or are connected in an overlapping manner at their ends and are wrapped and soldered together with the metal foil (16, 16a).

6. The superconductor of one of claims 1-5,
wherein the one or more connected HTS tape conductors (10) are wrapped with at least one further layer of metal foil (16b), so that the connection points of the windings of the first layer (16, 16a) are covered by the further layer (16b); and/or
wherein the one or more connected HTS tape conductors (10) comprise an enveloping Cu or Ag layer having a total thickness greater than 2 µm and preferably between 2 µm and 5 µm.

7. A method for producing a superconductor comprising:
spirally wrapping (610) an HTS tape conductor (10) with at least one layer of a metal foil (16, 16a), wherein the metal foil (16, 16a) comprises a solder coating (15);
heating (620) the metal foil above the melting point of the solder coating (15); and
subsequently cooling (630) below the melting point of the solder coating (15) to connect the metal foil (16, 16a) to the HTS tape conductor (10), thereby forming an armoring hermetically sealing the HTS tape conductor (10).

8. The method of claim 7, wherein the heating and/or the cooling takes place under the action of a contact pressure, the heating preferably by passing the wrapped HTS tape conductor (10) through hot rollers or through a hot bead.

9. The method of one of claims 7 or 8, wherein, during wrapping, a rotation frequency and an advance of the wrapping are set up such that the windings of the at least one layer of metal foil (16, 16a) lie close to each other without overlap and abut.

10. The method of one of claims 7 to 9, wherein, during wrapping, a rotation frequency and an advance of the wrapping are set such that a pitch angle (φ) of the windings is smaller than 45° and preferably between 20° and 30°.

11. The method of one of claims 7 to 10, wherein, during wrapping, the at least one layer of metal foil (16, 16a) is kept under a tensile stress between 10 MPa to 100 MPa.

12. The method of one of claims 7-11, further comprising:
sequentially wrapping the HTS tape conductor (10) with a plurality of mutually offset layers of metal foil (16, 16a, 16b), wherein the offset is preferably at least 20%, preferably half a bandwidth (B) of the metal foil.

13. The method of claim 12, wherein each layer is soldered individually.

14. The method of one of claims 7 to 13, further comprising
connecting a plurality of HTS tape conductors (10) one above the other or longitudinally; and
subsequently wrapping the connected HTS tape conductors (10).

15. The method of one of claims 7-14,
wherein the metal foil (16, 16a) comprises pure or low alloy Cu or Al; and/or
wherein the metal foil has a thickness between 10 µm and 100 µm, preferably between 20 µm and 50 µm; and/or
wherein the solder coating (15) is applied to at least one surface of the metal foil (16, 16a) and has a melting point below 280°C, preferably below 250°C, and a thickness between 2 µm and 30 µm, preferably between 5 µm and 15 µm.

## Revendications

1. Supraconducteur comprenant :
un conducteur en bande (10) supraconducteur à haute température, conducteur en bande HTS, et
au moins une couche de film métallique (16, 16a), qui est enroulée en spirale en plusieurs enroulements autour du conducteur en bande HTS (10) et est brasée avec celui-ci et forme ainsi une armature qui ferme hermétiquement le conducteur en bande HTS (10).

2. Supraconducteur selon la revendication 1,
dans lequel le film métallique (16, 16a) comporte du Cu ou de l'Al pur ou faiblement allié ; et/ou
dans lequel le film métallique (16, 16a) présente une épaisseur entre 10 µm et 100 µm, de manière préférée entre 20 µm et 50 µm ; et/ou
dans lequel une couche de brasage (15) est appliquée sur au moins une surface du film métallique (16, 16a), qui présente un point de fusion inférieur à 280 °C, de manière préférée inférieur à 250 °C, et présente une épaisseur entre 2 µm et 30 µm, de manière préférée entre 5 µm et 15 µm.

3. Supraconducteur selon l'une des revendications 1 ou 2,
dans lequel le film métallique (16, 16a) entoure le conducteur en bande HTS (10) sous un angle inférieur à 45°, de manière préférée sous un angle entre 20° et 30°, par rapport à la largeur du conducteur en bande HTS (10) ; et/ou
dans lequel les enroulements de l'au moins une couche de film métallique (16, 16a) sont étroitement rapprochés les uns des autres sans chevauchement et bout à bout.

4. Supraconducteur selon l'une des revendications 1 à 3, dans lequel la force d'adhérence du film métallique (16, 16a) sur le conducteur en bande HTS (10) est supérieure à 10 MPa lorsque le film métallique (16, 16a) est retiré dans une direction, qui se trouve à la normale à une surface du conducteur en bande HTS (10), définie de préférence par une mesure d'adhérence par traction selon la norme DIN EN ISO 4624:2016.

5. Supraconducteur selon l'une des revendications 1 à 4, comprenant en outre :
plusieurs conducteurs en bande HTS (10), qui forment entre eux un composite multicouche ou qui sont reliés en chevauchement sur leurs extrémités et qui sont enroulés ensemble du film métallique (16, 16a) et sont soudés.

6. Supraconducteur selon l'une des revendications 1 à 5,
dans lequel les un ou les plusieurs conducteurs en bande HTS (10) reliés sont enroulés d'au moins une autre couche de film métallique (16b) de telle sorte que les emplacements de liaison des enroulements de la première couche (16, 16a) sont recouverts par la couche supplémentaire (16b) ; et/ou
dans lequel les un ou les plusieurs conducteurs en bande HTS (10) reliés comprennent une couche enveloppante en Cu ou en Ag, qui présente une épaisseur totale supérieure à 2 µm et de manière préférée entre 2 µm et 5 µm.

7. Procédé de fabrication d'un supraconducteur, comprenant :
l'enroulement en spirale (610) d'un conducteur en bande HTS (10) d'au moins une couche d'un film métallique (16, 16a), dans lequel le film métallique (16, 16a) comporte un revêtement de brasage (15) ;
le chauffage (620) du film métallique (16, 16a) au-dessus du point de fusion du revêtement de brasage (15) ; et
le refroidissement (630) subséquent sous le point de fusion du revêtement de brasage (15) pour relier le film métallique (16, 16a) au conducteur en bande HTS (10) et former ainsi une armature, qui ferme hermétiquement le conducteur en bande HTS (10).

8. Procédé selon la revendication 7, dans lequel le chauffage et/ou le refroidissement sont effectués sous l'effet d'une pression de contact, le chauffage étant de préférence réalisé en guidant le conducteur en bande HTS (10) enroulé à travers des rouleaux chauds ou à travers un cordon chaud.

9. Procédé selon l'une des revendications 7 ou 8, dans lequel, lors de l'enroulement, une fréquence de rotation et une poussée de l'enroulement sont ajustées de telle manière que les enroulements de l'au moins une couche de film métallique (16, 16a) soient étroitement rapprochés les uns des autres sans chevauchement et en bout à bout.

10. Procédé selon l'une des revendications 7 à 9, dans lequel, lors de l'enroulement, une fréquence de rotation et une poussée de l'enroulement sont ajustées de telle manière qu'un angle d'inclinaison (φ) des enroulements est inférieur à 45° et se situe de manière préférée entre 20° et 30°.

11. Procédé selon l'une des revendications 7 à 10, dans lequel, lors de l'enroulement, l'au moins une couche de film métallique (16, 16a) est maintenue sous une contrainte de traction entre 10 MPa et 100 MPa.

12. Procédé selon l'une des revendications 7 à 11, comprenant en outre :
l'enroulement séquentiel du conducteur en bande HTS (10) avec plusieurs couches de film métallique (16, 16a, 16b) décalées les unes par rapport aux autres, dans lequel le décalage est de préférence d'au moins 20 %, de manière préférée d'une demi-largeur de bande (B) du film métallique.

13. Procédé selon la revendication 12, dans lequel chaque couche est soudée individuellement.

14. Procédé selon l'une des revendications 7 à 13, comprenant en outre :
la liaison de plusieurs conducteurs en bande HTS (10) les uns au-dessus des autres ou dans la longueur ; et
l'enroulement subséquent des conducteurs en bande HTS (10) reliés.

15. Procédé selon l'une des revendications 7 à 14,
dans lequel le film métallique (16, 16a) comporte du Cu ou de l'Al pur ou faiblement allié ; et/ou
dans lequel le film métallique présente une épaisseur entre 10 µm et 100 µm, de manière préférée entre 20 µm et 50 µm ; et/ou
dans lequel le revêtement de brasage (15) est appliqué sur au moins une surface du film métallique (16, 16a) et comporte un point de fusion inférieur à 280 °C, de manière préférée inférieur à 250 °C et comporte une épaisseur entre 2 µm et 30 µm, de manière préférée entre 5 µm et 15 µm.
